(19) Europäisches Patentamt
European Patent Office
Office européen des brevets

(11) **EP 3 819 930 A1**

(12) **EUROPEAN PATENT APPLICATION**
published in accordance with Art. 153(4) EPC

(43) Date of publication:
**12.05.2021 Bulletin 2021/19**

(51) Int Cl.:
***H01L 21/3065*** (2006.01)

(21) Application number: **20766387.3**

(22) Date of filing: **02.03.2020**

(86) International application number:
**PCT/JP2020/008659**

(87) International publication number:
**WO 2020/179729 (10.09.2020 Gazette 2020/37)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **04.03.2019 PCT/JP2019/008393**

(71) Applicant: SPP Technologies Co., Ltd.
**Tokyo 100-0003 (JP)**

(72) Inventors:
• **HANADA, Katsuji**
  **Amagasaki-shi, Hyogo 660-0891 (JP)**
• **FUJIWARA, Yuki**
  **Amagasaki-shi, Hyogo 660-0891 (JP)**

(74) Representative: **Grünecker Patent- und Rechtsanwälte**
**PartG mbB**
**Leopoldstraße 4**
**80802 München (DE)**

(54) **MANUFACTURING PROCESS DETERMINATION DEVICE FOR SUBSTRATE PROCESSING DEVICE, SUBSTRATE PROCESSING SYSTEM, MANUFACTURING PROCESS DETERMINATION DEVICE FOR SUBSTRATE PROCESSING DEVICE, GROUP OF LEARNING MODELS, METHOD FOR GENERATING GROUP OF LEARNING MODELS, AND PROGRAM**

(57) [Problem to be Solved] Provided are a production process determination device for a substrate processing apparatus, which can easily suppress deterioration of determination accuracy, and the like.

[Solution] A production process determination device 20 includes a process log acquisition section 21 that acquires process log data of a substrate processing apparatus 10, and a determination section 22 that creates input data based on the process log data and performs determination regarding production process in the substrate processing apparatus based on the input data. The determination section includes multiple learning models 25 each of which receives input of the input data and each of which outputs a determination result regarding the production process, and the multiple learning models are generated by performing machine learning by use of mutually different training datasets. The determination section can switch the learning model to be used for determination among the multiple learning models.

Fig. 1A

EP 3 819 930 A1

EP 3 819 930 A1

Fig. 1B

2

**Description**

[Technical Field]

The present invention relates to a production process determination device for a substrate processing apparatus, for performing determination regarding production process in the substrate processing apparatus, a substrate processing system including the same, a production process determination method for a substrate processing apparatus, a learning model group, a generation method of the learning model group, and a program. In particular, the present invention relates to a production process determination device for a substrate processing apparatus, a substrate processing system, a production process determination method for a substrate processing apparatus, a learning model group, a generation method of the learning model group, and a program, which can easily suppress deterioration of determination accuracy.

[Background Art]

Conventionally, as a device for performing determination regarding production process in a substrate processing apparatus such as a semiconductor producing apparatus, for example, devices according to

Patent Literatures 1 to 3 have been proposed.

The device according to Patent Literature 1 is a device for determining (predicting) a film thickness profile (specifically, an etching depth) of a substrate by using a learning model (a neural network) generated by performing machine learning.

The device according to Patent Literature 2 is a device for predicting an etching depth of a substrate, and thereby determining (detecting) an endpoint of etching by using a learning model (a neural network) generated by performing machine learning.

The device according to Patent Literature 3 is a device for determining (predicting) a failure of a substrate processing apparatus (specifically, an abnormality occurrence area and an estimated time for failure) by using a learning model (a support vector machine) generated by performing machine learning.

In a determination device including a learning model as described in Patent Literatures 1 to 3, the learning model is generated by performing machine learning by using a predetermined training dataset in an initial state (for example, before shipping of the substrate processing apparatus). Thereafter, after elapse of the initial state (for example, after shipping of the substrate processing apparatus), machine learning (relearning) of a learning model is commonly practiced again by using or adding a new training dataset for the purpose of improving determination accuracy.

However, for example, when the training dataset to be newly used or added is an inappropriate one in performing relearning of the learning model after elapse of the initial state, the determination accuracy may be deteriorated to be lower than when a learning model in the initial state (the learning model before relearning) is used. Since, even if the determination accuracy is deteriorated, it is not possible to return the already relearned learning model to its original state, relearning needs to be repeated until desired determination accuracy is accomplished, thus requiring a great amount of time and effort.

Moreover, relative superiority between the determination accuracy of the learning model before relearning and the determination accuracy of the learning model after relearning may change due to changes in the operating condition, etc. of the substrate processing apparatus. That is, there may be a case in which for a certain operating condition, determination accuracy is higher when the learning model before relearning is used, and for another operating condition, determination accuracy is higher when the learning model after relearning is used.

However, even in such a case, since, even if the determination accuracy of the relearned learning model is deteriorated, it is not possible to return the already relearned learning model to its original state, relearning needs to be repeated until desired determination accuracy is accomplished, thus requiring a great amount of time and effort.

Patent Literatures 1 to 3 have not disclosed anything about the means for solving the problems in the relearning of learning model as described above.

Incidentally, as shown in Patent Literature 4, there is known a determination device which includes a spectroscope as a device for determining (detecting) an endpoint of etching on a substrate in a substrate processing apparatus for performing etching processing on a substrate, though which does not use any learning model. Specifically, the determination device as described in Patent Literature 4 is a device which guides light generated in a chamber included in the substrate processing apparatus to a spectroscope installed outside the chamber, and determines (detects) the endpoint of etching on a substrate by measuring the intensity of light that has a predetermined wavelength with this spectroscope. For example, in the determination device according to Patent Literature 4, a time point at which the intensity of light having an emission wavelength of SiF which is a reaction product of Si becomes not more than a reference value is determined (detected) to be an endpoint of etching when a Si substrate is etched by using $SF_6$ gas as the processing gas.

Similarly, in a substrate processing apparatus that executes film deposition processing on a substrate, a determination device including a spectroscope is used when determining (detecting) an endpoint of etching on a film composition adhered to the inside of the chamber due to the film deposition processing. In such a determination device, when, for example, $C_4F_8$ gas is used as the processing gas to etch a film composition, a time point at which the intensity of light having an emission wavelength of F becomes not less than a reference value is determined (detected) as an endpoint of etching.

[Citation List]

[Patent Literature]

[Patent Literature 1] JP2009-534854A
[Patent Literature 2] JP2017-195365A
[Patent Literature 3] JP2018-178157A
[Patent Literature 4] JP4101280B

[Summary of Invention]

[Technical Problem]

The present invention has been made to solve the above described technical problems and has an objective to provide a production process determination device for a substrate processing apparatus, a substrate processing system, a production process determination method for a substrate processing apparatus, a learning model group, a generation method of the learning model group and a program, which can easily suppress deterioration of determination accuracy.

[Solution to Problem]

To achieve the above described objective, the present invention provides a production process determination device for a substrate processing apparatus, for performing determination regarding production process in the substrate processing apparatus, the production process determination device comprising: a process log acquisition section that is configured to acquire process log data of the substrate processing apparatus; and a determination section that is configured to create input data based on the process log data and to perform determination regarding production process in the substrate processing apparatus based on the input data, wherein the determination section includes multiple learning models each of which is configured to receive the input data and each of which is configured to output a determination result regarding the production process, and the multiple learning models are generated by performing machine learning by use of mutually different training datasets, and wherein the determination section is capable of switching a learning model to be used for determination among the multiple learning models.

According to the present invention, a determination section that is configured to perform determination regarding production process in a substrate processing apparatus includes multiple learning models, and these multiple learning models are generated by performing machine learning by use of mutually different training datasets. Then, the determination section can switch the learning model to be used for determination among the multiple learning models. For that reason, for example, by respectively evaluating the determination accuracy of the multiple learning models at an appropriate timing such as when the operating condition of the substrate processing apparatus is changed, and switching to use a learning model exhibiting highest determination accuracy, it is possible to easily suppress deterioration of determination accuracy.

In the present invention, it is also possible to manually perform evaluation of determination accuracy of multiple learning models, and instruction to the determination section for switching the learning model. However, performing these automatically is more effective and preferable.

Therefore, preferably, the determination section is configured to evaluate determination accuracy of each of the multiple learning models by using a test dataset, and thereafter to perform determination by using a learning model exhibiting highest determination accuracy.

According to the preferable configuration described above, since the determination section automatically evaluates the determination accuracy of each of multiple learning models, and automatically switches to a learning model exhibiting highest determination accuracy, it is possible to easily suppress deterioration of determination accuracy.

In the above described preferable configuration, the timing for evaluating the determination accuracy of the learning models may be set by time, etc. in advance, or manually instructed.

In the present invention, as in the above described preferable configuration, if determination accuracy of each of multiple learning models are evaluated, and determination thereafter is performed by use of a learning model exhibiting highest determination accuracy, although it is possible to suppress deterioration of determination accuracy, time and effort for preparing a test dataset is needed. To save this time and effort, it is preferable to decide that a majority decision of determination results of multiple learning models is the final determination result.

Therefore, preferably, the determination section is configured to output a majority decision of determination results of the multiple learning models as a final determination result.

According to the preferable configuration described above, since a majority decision of determination results of multiple learning models is decided as the final determination result, it is possible to make determination accuracy of final determination results reliable even if determination accuracy of each learning model is not frequently evaluated.

Incidentally, when the multiple learning models are an even number of learning models, the number of learning models that output the same determination result may become the same. When the number becomes the same, it is conceivable that a predetermined evaluation result is output as the final determination result. For example, in a case in which the determination section includes 4 learning models, and determines whether it is before or after the endpoint of etching as in the below described first embodiment of the present invention, when any two learning models determine that it is before the endpoint of etching, and the remaining two learning models determine that it is after the endpoint of etching, since the number is the same, it may be decided in advance such that the final determination result is before the endpoint of etching.

Preferably, the multiple learning models include a learning model generated by performing machine learning by use of only a training dataset obtained in an initial state of the substrate processing apparatus, and a learning model generated by performing machine learning by use of a training dataset including a training dataset obtained after elapse of the initial state of the substrate processing apparatus.

According to the preferable configuration described above, when the determination accuracy of the learning model after elapse of an initial state (for example, a learning model generated by performing machine learning by use of the training dataset including the training dataset obtained after shipping of the substrate processing apparatus) is lower than the determination accuracy of the learning model of initial state (for example, a learning model generated by performing machine learning by use of only the training dataset obtained before shipping of the substrate processing apparatus), it is possible to change to and use the learning model of initial state.

Further, even when relative superiority between the determination accuracy of the learning model of initial state and the determination accuracy of the learning model after elapse of an initial state has changed due to changes in the operating condition, etc. of the substrate processing apparatus, it is possible to change to and use either one learning model with higher determination accuracy.

To achieve the above described objective, the present invention also provides a substrate processing system comprising: a substrate processing apparatus; and the production process determination device according to any of the above.

To achieve the above described objective, the present invention also provides a production process determination method for a substrate processing apparatus, comprising: a process log acquisition step of acquiring process log data of a substrate processing apparatus; and a determination step of creating input data based on the process log data acquired by the process log acquisition step, and performing determination regarding production process in the substrate processing apparatus based on the input data, wherein in the determination step, multiple learning models generated by performing machine learning by use of mutually different training datasets are prepared, and the input data is input to at least any one learning model of the multiple learning models, and determination result regarding the production process is output from the at least any one learning model.

To achieve the above described objective, the present invention also provides a learning model group, comprising multiple learning models, each of which is configured to receive input data created based on process log data of a substrate processing apparatus, and each of which is configured to output a determination result regarding production process in the substrate processing apparatus, wherein the multiple learning models are generated by performing machine learning by use of mutually different training datasets.

To achieve the above described objective, the present invention also provides a generation method of a learning model group including multiple learning models, wherein each of the multiple learning models is configured to receive input data created based on process log data of a substrate processing apparatus, and to output a determination result regarding production process in the substrate processing apparatus, and wherein the multiple learning models are generated by performing machine learning by use of mutually different training datasets.

To achieve the above described objective, the present invention further provides a program for causing a computer to execute the process log acquisition step and the determination step included in the production process determination method for a substrate processing apparatus.

Incidentally, the present invention can be provided as a storage medium which can be read by a computer (CPU), and in which the above described program is stored.

[Advantageous Effects of Invention]

According to the present invention, it is possible to easily suppress deterioration of determination accuracy.

[Brief Description of Drawings]

[Figs. 1A, 1B, and 1C] Figs. 1A, 1B, and 1C are schematic diagrams for showing an outline configuration of a substrate processing system according to a first embodiment of the present invention.
[Figs. 2A, 2B, and 2C] Figs. 2A, 2B, and 2C are explanatory diagrams for illustrating actions of a normalizing section and an imaging section shown in Fig. 1B.
[Fig. 3] Fig. 3 is a schematic diagram for showing an outline configuration and action of the learning model shown in Fig. 1B.

[Figs. 4A and 4B] Figs. 4A and 4B are flow diagrams for showing operating procedures at the time of learning and at the time of determination of the learning model shown in Fig. 1B.

[Figs. 5A and 5B] Figs. 5A and 5B are block diagrams for showing a variant of the production process determination device shown in Figs. 1B and 1C.

[Fig. 6] Fig. 6 shows results of a test using the substrate processing system shown in Fig. 1A.

[Fig. 7] Fig. 7 is a schematic diagram for showing an outline configuration of a substrate processing system according to a second embodiment of the present invention.

[Fig. 8] Fig. 8 shows results of a test using the substrate processing system shown in Fig. 7.

[Description of Embodiments]

Hereinafter, referring to the attached drawings, a production process determination device according to an embodiment of the present invention, and a substrate processing system including the same will be described. In the present embodiment, description will be made by taking an example of a case in which the substrate processing apparatus is a plasma processing apparatus, and an endpoint of etching is detected as determination regarding production process in the substrate processing apparatus.

First, meanings of the expressions used in the present specification will be described.

In the present specification, the expression "determination regarding production process in a substrate processing apparatus" means detection and prediction regarding a production process in a substrate processing apparatus (meaning a production process of a substrate in a substrate processing apparatus). The expression, a production process in a substrate processing apparatus, means a process that is performed during the processing of a substrate and before or after the processing in the substrate processing apparatus. Therefore, the determination regarding production process in a substrate processing apparatus does not include determination regarding inspection of a substrate after processing (particularly, inspection of a substrate that is transferred outside the substrate processing apparatus after being processed within the substrate processing apparatus). Specifically, abnormality detection in the production process in the substrate processing apparatus, detection of an etching endpoint in the production process in the substrate processing apparatus that performs the etching processing, prediction of etching shape/depth, prediction of quality of a film deposited in the production process in the substrate processing apparatus that performs film deposition processing, and the like can be exemplified. Incidentally, since the production process determination device according to the present embodiment performs determination regarding production process in a substrate processing apparatus, the determination result thereof may directly contribute to performance enhancement and yield ratio improvement of the substrate after being processed by the substrate processing apparatus. In contrast, even if determination regarding inspection of a substrate after processing is performed, only the quality of the inspected substrate itself can be determined, and therefore, the determination result will not directly contribute to the performance enhancement and yield rate improvement of the substrate after processing in the substrate processing apparatus.

Further, in the present specification, "process log data of substrate processing apparatus" means histories of various measured values and set values regarding the processing of a substrate in the substrate processing apparatus, and is generally obtained sequentially while the substrate processing apparatus is working. However, the process log data may include measured values regarding inspection of a substrate after processing (inspection of a substrate transferred to the outside of the substrate processing apparatus). This is because, since the inspection result of a substrate may vary depending on the quality of the processing of the substrate, measured values regarding the inspection of a substrate after processing can be measured values regarding the processing of the substrate in the substrate processing apparatus.

Further, in the present specification, as the "learning model", various configurations may be adopted as long as they can be generated by using machine learning, such as neural networks, and support-vector machines.

Furthermore, in the present specification, " training dataset" means a combination of known inputs and outputs to and from a learning model, and "mutually different training datasets" mean that they will not be limited to a case in which the combinations of input and output are completely different, and will include a case in which the combinations partially overlap.

Moreover, in the present specification, the expression "can switch a learning model to be used for determination among the multiple learning models" does not mean to be limited to a case in which the learning model is switched to any one of the multiple learning models, and determination is performed by using only one selected learning model. It is meant to include such a case in which the learning model is switched to two of the three learning models, and determination is made by using these two learning models, or determination is made by using all of the multiple learning models, for example.

Furthermore, in the present specification, "test dataset" means a combination of known inputs and outputs to and from a learning model, and "determination accuracy" means a degree of agreement to which the determination result output by the learning model agrees with the output of the test dataset (true determination result).

Furthermore, in the present specification, "majority decision of determination results of multiple learning models is output as the final determination result" is an idea to include a case in which when the numbers of learning models that output the same determination result become the same, predetermined one of the determination results is output as the final determination result.

<First embodiment>

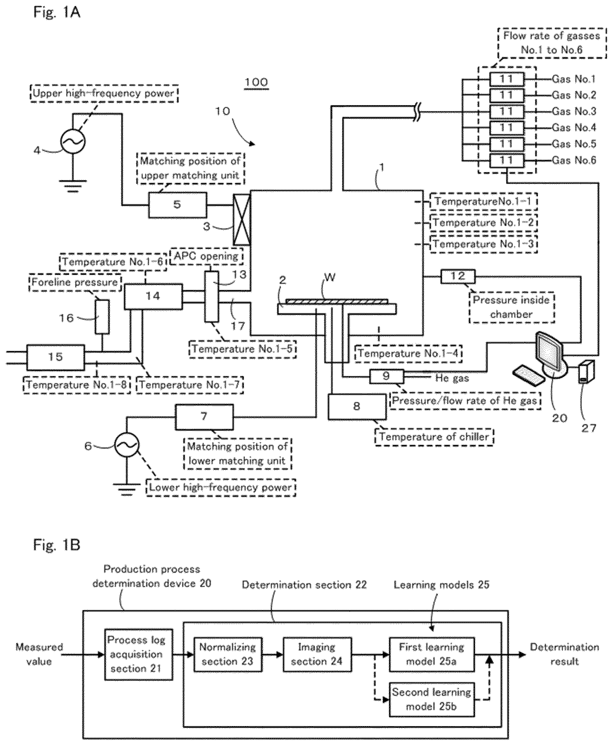

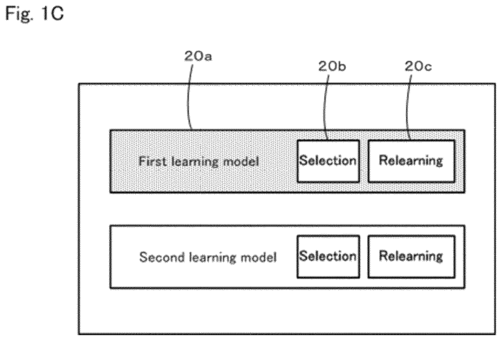

Figs. 1A, 1B and 1C are schematic diagrams for showing an outline configuration of a substrate processing system according to the first embodiment. Fig. 1A is a general configuration diagram of the substrate processing system. Fig. 1B is a block diagram for showing an outline configuration of a production process determination device. Fig. 1C is a schematic diagram for showing a display example of a monitor screen of a computer constituting the production process determination device. Incidentally, in Fig. 1A, parameters to be measured are illustrated by surrounding them with a rectangle of broken line.

As shown in Fig. 1A, the substrate processing system 100 according to the first embodiment includes a substrate processing apparatus 10 and a production process determination device 20.

The substrate processing apparatus 10 of the first embodiment, which includes a chamber 1 and a mounting table 2 disposed in the chamber 1, is an apparatus for conducting plasma processing on a substrate W mounted on the mounting table 2. To be more specific, the substrate processing apparatus 10 of the first embodiment is a plasma etching apparatus for inductively coupled plasma (ICP) method for conducting etching on the substrate W as the plasma processing. When conducting etching on the substrate W in the substrate processing apparatus 10, it is important to determine (detect) an endpoint of etching so that the substrate W will not be excessively etched.

Processing gas for generating plasma is supplied from a gas source (not shown) into the chamber 1 of the substrate processing apparatus 10. In Fig. 1A, a configuration in which six kinds of processing gasses from gas No. 1 to gas No. 6 can be supplied is shown. However, performing the etching processing will not be limited to a case in which all of the six kinds of processing gasses are used, and it is possible to perform etching by using any one or more kinds of the processing gas. Incidentally, the flow rate of each processing gas to be supplied is measured by a mass flow controller (MFC) 11 provided in a flow path from the gas source to the chamber 1. Moreover, a heater (not shown) for heating the wall surface of the chamber 1 is provided in appropriate places in the chamber 1, and the temperature of the heater at each place (Temperature No. 1-1 to No. 1-4 shown in Fig. 1A) is measured by a known measurement instrument (not shown) such as a thermocouple. Further, the pressure inside the chamber 1 is measured by a vacuum gauge 12.

The substrate processing apparatus 10 includes coils 3 which are disposed in the chamber 1 in such a way to surround the chamber 1 (only the cross section of the coil 3 located on the left side is shown for convenience in Fig. 1A). High frequency power (upper high-frequency power) is applied to the coil 3 from an upper high-frequency power supply 4 via an upper matching unit 5. As a result of applying upper high-frequency power to the coil 3, the processing gas supplied into the chamber 1 will be turned into plasma. Incidentally, the upper high-frequency power applied by the upper high-frequency power supply 4, and a matching position of the upper matching unit 5 (constants of variable capacitors and variable coils, etc. included in the upper matching unit 5) are measured respectively by a known measurement instrument (not shown).

High-frequency power (lower high-frequency power) is applied to the mounting table 2 from a lower high-frequency power supply 6 via a lower matching unit 7. Applying lower high-frequency power to the mounting table 2 will give bias potential to between the mounting table 2 and the plasma in the chamber 1, thereby accelerating ions in the plasma to bring them into the substrate W mounted on the mounting table 2. As a result of this, the substrate W is subjected to etching. Incidentally, the lower high-frequency power applied by the lower high-frequency power supply 6, and the matching position of the lower matching unit 7 (constants of variable capacitors and variable coils, etc. included in the lower matching unit 7) are measured respectively by a known measurement instrument (not shown).

During execution of plasma processing, the mounting table 2 is cooled by a chiller 8. The temperature of the chiller 8 is measured by a known measurement instrument (not shown) such as a thermocouple. Further, during execution of plasma processing, He gas is supplied to a rear face of the substrate W, and the substrate W is cooled by the He gas. At this time, the pressure/flow rate of the He gas to be supplied is measured by a pressure/flow meter 9 provided in a flow path from the He gas source (not shown) to the rear face of the substrate W (upper face of the mounting table 2).

Reaction products, etc. which have been produced in the chamber 1 as a result of performing the plasma processing are discharged to the outside of the chamber 1 through an exhaust pipe 17 which is in communication with the inside of the chamber 1. There are provided in the exhaust pipe 17, an auto pressure controller (APC) 13 that controls the pressure in the chamber 1 by adjusting valve opening, a first pump (a turbo-molecular pump) 14 for discharging reaction products, and a second pump (a drive pump, a rotary pump, etc.) 15 that assists the first pump 14. Incidentally, temperature of the auto pressure controller 13 (Temperature No. 1-5 shown in Fig. 1A) and temperature of the first pump 14 (Temperature No. 1-6 shown in Fig. 1A) are measured with a known measurement instrument (not shown) such as a thermocouple. Moreover, the exhaust pipe 17 is provided with a heater (not shown) for heating the exhaust pipe 17 in an appropriate place (for example, between the first pump 14 and the second pump 15), and the temperature of the heater in each place (Temperatures No. 1-7 and No. 1-8 shown in Fig. 1A) is measured with a known measurement instrument (not shown) such as a thermocouple. Further, the valve opening of the auto pressure controller 13 (APC opening) is measured with a known measurement instrument (not shown) such as an encoder. Furthermore, pressure (foreline pressure) in the exhaust pipe 17 located between the first pump 14 and the second pump 15 is measured with a vacuum gauge 16.

The production process determination device 20 of the first embodiment, which is electrically connected to the substrate processing apparatus 10 having the above described configuration, is a device that determines (detects) an endpoint of etching applied to the substrate W in the substrate processing apparatus 10.

As shown in Fig. 1B, the production process determination device 20, which includes a process log acquisition section 21 and a determination section 22, is constituted by, for example, a computer.

The process log acquisition section 21, which is electrically connected with wire or wirelessly with a measurement instrument (for example, a mass flow controller 11) that measures each measured value described with reference to Fig. 1A (in Fig. 1A, for convenience, a state of being connected with wire only to the pressure/flow meter 9, the mass flow controller 11, and the vacuum gauge 12 is illustrated), has a function of acquiring (A/D converting) the measured data sequentially input from each measurement instrument at a predetermined sampling period (for example, 1 sec). The process log acquisition section 21 is constituted by, for example, an A/D conversion board equipped in a computer, a memory such as ROM and RAM included in a computer, and a program which is stored in the memory and causes a CPU to execute an action as the process log acquisition section 21. The program may be in a mode in which it is stored in a hard disk 27 which is an external storage medium included in the production process determination device 20 and is read from the hard disk 27 into a RAM. Thus acquired each measured value and each set value corresponding to the each measured value are used, as process log data, for detecting the endpoint of etching in the determination section 22.

Incidentally, the process log data used in the first embodiment does not include any measured value regarding the light generated in the chamber 1 (light generated according to the component of the processing gas supplied into the chamber 1 and the substrate W). That is, light intensity values measured by use of a conventional spectroscope are excluded. In other words, there is no need of using a spectroscope when detecting the endpoint of etching. Moreover, the process log data to be used in the first embodiment does not include measured values and set values regarding the position of the substrate W outside of the substrate processing apparatus 10.

Further, in the first embodiment, although all the measured values shown in Fig. 1A are used as process log data for detecting the endpoint of etching, the present invention will not be limited to this. However, it is preferable to use, at least, the foreline pressure or the APC opening, and the matching position of the upper matching unit 5 and/or the lower matching unit 7.

According to results of diligent studies by the present inventors, among various kinds of process log data, the pressure (foreline pressure) in the exhaust pipe 17, the valve opening (APC opening) of the auto pressure controller 13, the matching position of the upper matching unit 5, and the matching position of the lower matching unit 7 are particularly likely to vary between before and after an endpoint of etching. This is because when etching ends, a layer to be etched on the substrate W disappears and thereby the state of plasma will change. For that reason, to determine (detect) the endpoint of etching, it is preferable to use at least these process log data as described above. However, since the foreline pressure and the APC opening change in a substantially interlocked manner, using only either one of them is conceivably sufficient.

Incidentally, when the production process determination device 20 also has a function as a controller which is generally used for controlling the working of the substrate processing apparatus 10 (when the controller is used as the production process determination device 20 at the same time), each set value constituting the process log data is stored in the production process determination device 20 (the process log acquisition section 21) in advance. When the production process determination device 20 is a different body from the above described controller, and the both are electrically connected, each set value stored in the controller in advance will be transmitted to the production process determination device 20 (the process log acquisition section 21). Further, although a case in which the production process determination device 20 is directly connected with each measurement instrument is exemplified in the first embodiment, it is also possible to adopt a configuration in which the above described controller and each measurement instrument are directly connected with each other, and each measured value acquired in the controller is transmitted to the production process determination device 20.

The determination section 22 is a section that creates input data from the process log data sequentially acquired (for example, every one second) by the process log acquisition section 21 and, based on the input data, determines (detects) the endpoint of etching in the substrate processing apparatus 10. The determination section 22 is constituted by, for example, a memory such as ROM and RAM included in a computer, and a program which is stored in the memory and causes a CPU to execute actions as the determination section 22. This program may be in a mode in which it is also stored in the hard disk 27, and is read from the hard disk 27 to RAM.

The determination section 22 includes multiple learning models 25. In the example shown in Fig. 1B, although the determination section 22 includes two learning models 25 (a first learning models 25a and a second learning model 25b), the present invention will not be limited to these, and it may include three or more learning models 25. The first learning model 25a and the second learning model 25b have the same configuration, but are generated by performing machine learning by use of mutually different training datasets. For example, the first learning model 25a is generated by performing machine learning by use of only the training dataset obtained before shipping of the substrate processing apparatus 10, and the second learning model 25b is generated by performing machine learning by use of the training datasets obtained before shipping and after shipping of the substrate processing apparatus 10. Incidentally, "before shipping" according to the present specification will not be limited to a state in which the substrate processing apparatus 10 is present at the side of the manufacturer of the substrate processing apparatus 10. When the manufacturer side visits the user side to perform adjustment of the start-up of the substrate processing apparatus 10 after the substrate processing apparatus 10 is delivered from the manufacturer side to the user side, "before shipping" is a concept including such a start-up adjustment period.

Then, the determination section 22 is configured to be switchable between learning models, which are the first learning model 25a and the second learning model 25b, to be used for performing determination. Switching of the learning model 25 to be used for determination may be done by manually giving instruction for switching to the determination section 22, or may be done automatically by the determination section 22 as described later.

The example shown in Fig. 1B illustrates a state in which the first learning model 25a is selected, and the below described imaging section 24 and the first learning model 25a are connected to perform determination by using the first learning model 25a.

For example, there is a case in which the training dataset obtained after shipping is not appropriate because of that the utility specification is different, or the clean room environment is different between before shipping and after shipping. Moreover, even after shipping, there is a case in which the material and size of the substrate W is different, or the processing gas for generating plasma is different because of performance enhancement/production process improvement, and usage change, etc. of devices in the substrate processing apparatus. In such cases, there is a possibility that using the first learning model 25a which has been subjected to learning by using only the training dataset obtained before shipping exhibits higher determination accuracy.

Incidentally, as described above, the determination section 22 can also include three or more learning models. In particular, it is preferable to prepare training datasets, which are mutually different though obtained equally after shipping, in response to performance enhancement/production process improvement, and usage change, etc. of devices in the substrate processing apparatus after shipping as described above, and perform machine learning by respectively using these different training datasets after shipping, thereby generating multiple learning models 25.

The determination section 22 of the first embodiment further includes, as a preferable configuration, a normalizing section 23 and an imaging section 24. The normalizing section 23, the imaging section 24, and the learning model 25 are also constituted by a memory such as ROM, RAM, etc. included in a computer, and a program which is stored in the memory and causes a CPU to execute actions as each section 23 to 25. This program may be in a mode in which it is also stored in the hard disk 27, and is read from the hard disk 27 to RAM.

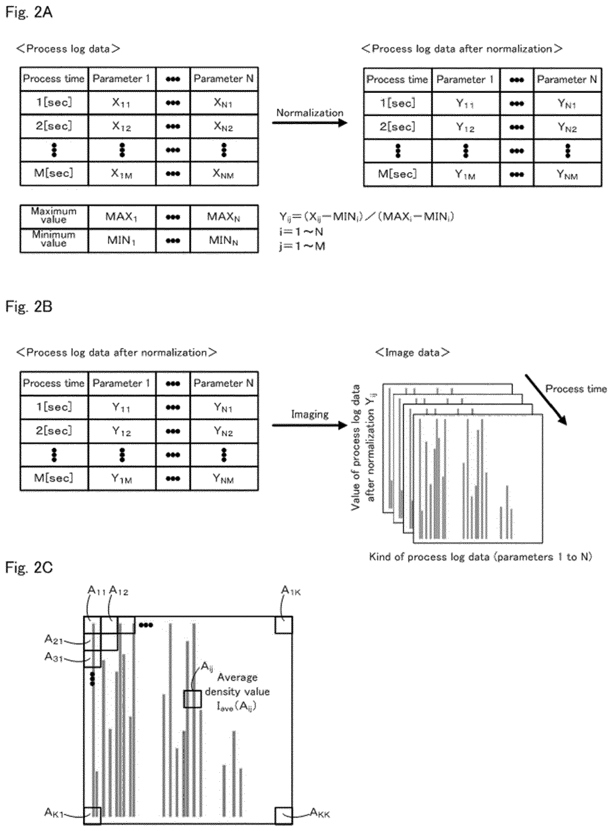

Figs. 2A, 2B and 2C are explanatory diagrams for illustrating actions of the normalizing section 23 and the imaging section 24. Fig. 2A is a diagram for illustrating the actions of the normalizing section 23 and Figs. 2B and 2C are diagrams for illustrating the actions of the imaging section 24.

The left side figure of Fig. 2A is a schematic diagram for showing process log data acquired by a process log acquisition section 21. Parameters 1 to N shown in Fig. 2A means, for example, kinds of process log data in such a way as that Parameter 1 is the flow rate of Gas No. 1 measured by the mass flow controller 11 shown in Fig. 1A, and Parameter N is Temperature No. 1-8 shown in Fig. 1A. $X_{ij}$ (i=1 to N, j=1 to M) shown in the left side figure of Fig. 2A means values of the process log data acquired for Parameter i when the process time (elapsed time from the start of etching) is j [sec]. For example, $X_{11}$ is a value of process log data for Parameter 1 acquired when the process time is 1 [sec], and $X_{NM}$ is a value of process log data acquired for Parameter N when the process time is M [sec].

The normalizing section 23 calculates, in advance, a maximum value $MAX_i$, a minimum value $MIN_i$ of process log data at all the process times (1 to M [sec]) for each kind of process log data (for each Parameter i). For example, a maximum value is $MAX_1$ and a minimum value is $MIN_1$ for Parameter 1, and a maximum value is $MAX_N$ and a minimum value is $MIN_N$ for parameter N. Incidentally, it is preferable that these maximum value $MAX_i$ and minimum value $MIN_i$ are not calculated by using process log data acquired when a single substrate W is etched, but are calculated, in advance, by using process log data acquired for multiple substrates W which have been etched with an equivalent recipe (a condition of plasma processing) at the time of learning of the below described learning model 25, etc. The calculated maximum value $MAX_i$ and the minimum value $MIN_i$ for each kind of the process log data (for each Parameter i) are stored in the normalizing section 23.

Then, the normalizing section 23 performs normalization for process log data $X_{ij}$ sequentially acquired by the process log acquisition section 21 such that the maximum value is 1 and the minimum value is 0 for each kind of process log data (for each Parameter i).

Specifically, as shown in the right side figure of Fig. 2A, process log data $Y_{ij}$ after normalization is calculated based on the following Formula (1).

$$Y_{ij} = (X_{ij} - MIN_i)/(MAX_i - MIN_i) \quad ...(1)$$

In the above Formula (1), i = 1 to M, and j = 1 to N.

From the above Formula (1), it is clear that normalization will be done such that when $X_{ij} = MAX_i$, $Y_{ij} = 1$, and when $X_{ij} = MIN_i$, $Y_{ij} = 0$.

The value of process log data $X_{ij}$ will significantly differ according to the kinds of the process log data $X_{ij}$ such as pressure, temperature, flow rate. Moreover, the value will differ depending on the unit in which it is represented. For that reason, if the value of process log data $X_{ij}$ of each kind is used as it is when determining (detecting) the endpoint of etching, the determination accuracy may possibly be affected. In order to avoid this, it is preferable to perform normalization as described above such that any of the value of process log data $Y_{ij}$ of each kind after normalization fluctuates within a certain range.

The imaging section 24 creates input data to the learning model 25 based on the process log data after normalization.

Specifically, the imaging section 24 successively creates (for example, every one second) image data obtained by imaging a graph (bar graph) in which as shown in the right side figure of Fig. 2B, one axis (the abscissa in the example shown in the right side figure of Fig. 2B) is the kind of process log data (Parameters 1 to N), and another axis orthogonal to the one axis (the ordinate in the example shown in the right side figure of Fig. 2B) is the value of process log data $Y_{ij}$ after normalization, based on the process log data after normalization as shown in the left side figure of Fig. 2B.

The kind of the image data will not be limited to a monochromatic grayscale image as shown in the right side figure of Fig. 2B, and any image data such as a binary image and a color image can be created.

Next, the imaging section 24 of the first embodiment divides the created image data into a predetermined pixel region which is constituted by multiple pixels.

Specifically, as shown in Fig. 2C, the imaging section 24 divides image data into K parts respectively in one axis (abscissa) direction and another axis (ordinate) direction to create pixel regions $A_{ij}$ (i = 1 to K, j = 1 to K). Then, for each pixel region $A_{ij}$, the imaging section 24 calculates an average density value (an average value of density values of multiple pixels constituting the pixel region $A_{ij}$) $I_{ave}(A_{ij})$ (i = 1 to K, j = 1 to K). This average

density value $I_{ave}(A_{ij})$ is used as input data to the learning model 25.

Incidentally, when the imaging section 24 creates a color image (a color image of three colors, RGB), the imaging section 24 calculates an average density value for an image of each color, and all of them are used as input data to the learning model 25.

Moreover, although in the first embodiment, a case in which the imaging section 24 divides the image data into pixel regions has been shown, the present invention will not be limited to this, and the density value of each pixel constituting the image data may be used as it is as input data to the learning model 25.

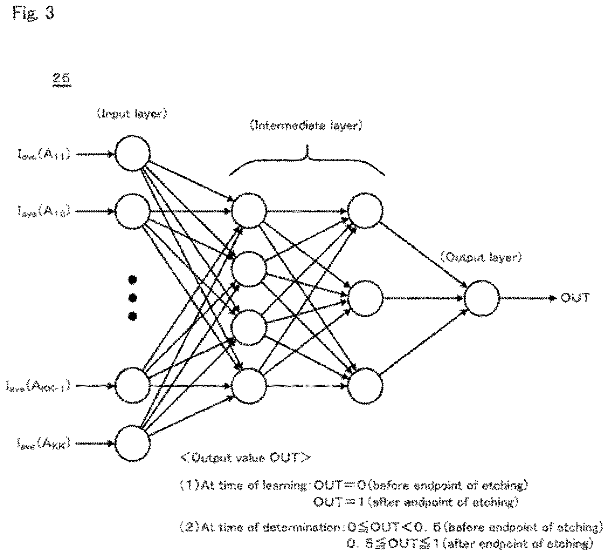

Fig. 3 is a schematic diagram for illustrating a general configuration and actions of a learning model 25 (a first learning model 25a and a second learning model 25b).

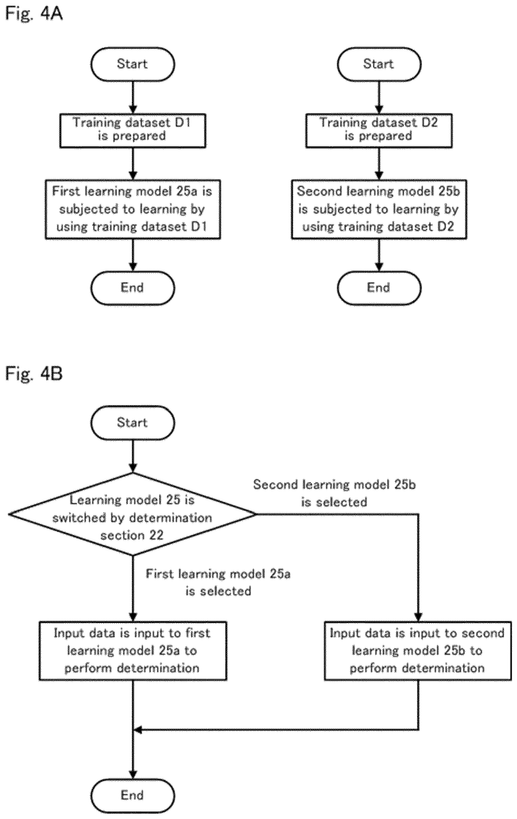

Figs. 4A and 4B are flow diagrams for illustrating operating procedure at the time of learning and determination of the learning model 25. Fig. 4A shows operating procedure at the time of learning, and Fig. 4B shows operating procedure at the time of determination.

As shown in Fig. 3, the learning model 25 of the first embodiment is constituted by a neural network having an input layer, an intermediate layer, and an output layer. Although a configuration having two intermediate layers is exemplified in Fig. 3, the neural network usable as the learning model of the present invention is not limited to this, and a configuration having any number of intermediate layers can be adopted. Moreover, the number of nodes (portions indicated by "○" in Fig. 3) of each layer shown in Fig. 3 is merely an example, and the number of nodes in the neural network which can be used as the learning model of the present invention will not be limited to that shown in the figure.

The learning model 25 is generated by machine learning such that when image data (specifically, an average density value $I_{ave}(A_{ij})$ of each pixel region $A_{ij}$) created in the imaging section 24 as input data is input to the input layer, whether it is before or after the endpoint of etching in the substrate processing apparatus 10 is output (output value OUT is output) from the output layer.

Specifically, at the time of learning of the learning model 25, as the input of the training dataset, input data (image data) created from process log data acquired before the endpoint of etching is given. Moreover, as the output of the training dataset to be combined with the input, "before the endpoint of etching" (OUT = 0 in the first embodiment) is given. Then, machine learning is performed such that when the input is input to the input layer, OUT = 0 is output from the output layer.

Moreover, as the input of the training dataset, input data (image data) created from process log data acquired after the endpoint of etching is given. Moreover, as the output of the training dataset to be combined with the input, "after the endpoint of etching" (OUT = 1 in the first embodiment) is given. Then, machine learning is performed such that when the input is input to the input layer, OUT = 1 is output from the output layer.

As described before, although, in the first learning model 25a and the second learning model 25b, mutually different training datasets are used, the method of machine learning is the same. Specifically, as shown in Fig. 4A, a training dataset D1 for the first learning model 25a is prepared, and the first learning model 25a is subjected to learning by using this training dataset D1. Moreover, a training dataset D2 for the second learning model 25b, which is different from the training dataset D1, is prepared, and the second learning model 25b is subjected to learning using this training dataset D2.

Incidentally, the first learning model 25a and the second learning model 25b will not be limited to those which are generated by performing machine learning once. When necessary, it is also possible to perform relearning of the first learning model 25a and the second learning model 25b by using a new training dataset, and to perform relearning of the first learning model 25a and the second learning model 25b by adding the new training dataset to the existing training dataset. Whether or not relearning of the first learning model 25a and the second learning model 25b is performed may be instructed by displaying run buttons 20c for performing relearning of the first learning model 25a and the second learning model 25b respectively on a monitor screen of a computer constituting the production process determination device 20 as shown in Fig. 1C, for example. Then, it may be configured such that relearning of the learning model 25 corresponding to each run button 20c is executed by clicking each run button 20c by using a keyboard or mouse, or by touching each run button 20c with a finger when the monitor is of a touch-panel type.

Incidentally, when the substrate processing apparatus 10 includes a spectroscope, the spectroscope may be used to acquire a training dataset. Specifically, whether process log data which serves as a base of input data to be used as the training dataset is acquired before the endpoint of etching, or acquired after the endpoint of etching may be determined by measuring the intensity of light having a predetermined wavelength with the spectroscope. That is, the endpoint of etching is detected by using the spectroscope, and supposing the endpoint of etching detected by this spectroscope being true, whether the process log data is acquired before the true endpoint or acquired after the true endpoint is determined to acquire the training dataset.

Moreover, when the substrate processing apparatus 10 does not include any spectroscope, a training dataset may be acquired by using another substrate processing apparatus including a spectroscope. That is, it is also possible to generate a learning model 25 by machine learning by use of another substrate processing apparatus including a spectroscope, and to use this learning model 25 in the production process determination device 20 to be applied to the substrate processing apparatus 10 of the first embodiment.

Further, when the substrate processing apparatus 10 includes multiple chambers 1 for executing etching processing, the production process determination device 20 is applied to each chamber 1, and only some chambers 1 include a spectroscope, a training dataset may be acquired by using another chamber 1 including a spectroscope. That is, it is also possible to generate a learning model 25 by machine learning by use of another chamber 1 including a spectroscope, and use this learning model 25 in the production process determination device 20 for a chamber 1 which includes no spectroscope. This mode is particularly effective, when etching processing is executed in parallel with the same kind of recipe in multiple chambers 1.

Further, it is not always limited to a case of acquiring a training dataset by using a spectroscope. For example, it is conceivable to observe the surface of the substrate W during etching when acquiring the training dataset, and determine whether process log data is obtained before or after the endpoint of etching from the difference in the color of the surface of the substrate W depending on before or after the endpoint of etching, thereby acquiring the training dataset.

At the time of determination to determine (detect) the endpoint of etching based on sequentially input input data by the learning model 25 after the learning as described above, input data (image data) is sequentially input to the input layer of the learning model 25, and output values OUT are output from the output layer of the learning model 25. In contrast to the time of learning, the value of the output value OUT at the time of determination will be $0 \leq OUT \leq 1$.

Specifically, as shown in Fig. 4B, the determination section 22 switches the learning model 25 to be used for determination between the first learning model 25a and the second learning model 25b. When the first learning model 25a is selected, input data is sequentially input to the input layer of the first learning model 25a to perform determination. When the second learning model 25b is selected, input data is sequentially input to the input layer of the second learning model 25b to perform determination.

Incidentally, in the example shown in Fig. 1B, since the first learning model 25a is selected, input data (image data) is sequentially input to the input layer of the first learning model 25a, and output value OUT is output from the output layer of the first learning model 25a. When the second learning model 25b is selected, input data (image data) is sequentially input to the input layer of the second learning model 25b, and output value OUT is output from the output layer of the second learning model 25a.

The determination section 22 of the first embodiment is configured to determine such that when $0 \leq OUT < 0.5$ (0 when rounded at the first decimal place), it is determined to be before the endpoint of etching, and when $0.5 \leq OUT \leq 1$ (1 when rounded at the first decimal place), it is determined to be after the endpoint of etching. In other words, the determination section 22 of the first embodiment is configured to compare the output value OUT with a predetermined threshold (threshold = 0.5 in the above example) so that if the output value OUT is less than the threshold, it is determined to be before the endpoint of etching, and if the output value OUT is not less than the threshold, it is determined to be after the endpoint of etching.

By the production process determination device 20 having the configuration described above, the endpoint of etching to be applied to the substrate W in the substrate processing apparatus 10 is sequentially determined (detected).

Incidentally, switching of the learning model 25 to be used for determination between the first learning model 25a and the second learning model 25b can be performed automatically, for example, in the following manner. That is, a test dataset, which has been acquired in the same manner as with the training dataset, (combination of known inputs and outputs to and from the learning model 25) is stored in the determination section 22 in advance. Next, the determination section 22 evaluates determination accuracy of the first learning model 25a and the second learning model 25b respectively by using the test dataset. Then, the determination section 22 may be configured to perform determination thereafter by using the learning model 25 exhibiting higher determination accuracy. The timing for evaluating the determination accuracy of each learning model 25 may be set by time, etc. in advance, or manually instructed (for example, evaluation start is instructed with a keyboard, a mouse, a touch panel, or the like included in the production process determination device 20).

When switching of the learning model 25 to be used for determination between the first learning model 25a and the second learning model 25b is manually instructed to the determination section 22, for example, the determination accuracy of the first learning model 25a and the second learning model 25b is manually evaluated respectively by using the test dataset as same as above (however, in this case, there is no need of storing the test dataset in the determination section 22), and switching to the learning model 25 exhibiting higher determination accuracy may be manually instructed.

The first embodiment is configured such that the learning model 25 to be used for determination is displayed on the monitor screen of a computer constituting the production process determination device 20. Specifically, when instruction to the determination section 22 for switching the learning model 25 is manually performed, for example, as shown in Fig. 1C, selection buttons 20b for the first learning model 25a and the second learning model 25b are displayed respectively on the monitor. Then, it is possible to adopt a mode in which the selected learning model 25 is displayed so as to be discriminable from other learning models 25 by selecting any selection button 20b by using a keyboard or a mouse, or by selecting any selection button 20b with a finger when the monitor is of a touch panel type. For example, in an example shown in Fig. 1C, a display field 20a for the selected learning model 25 (the first learning model 25a) is lighting displayed on the monitor. Without being limited to lighting display, various modes such as blinking display and color display can be adopted as long as the selected learning model 25 is discriminable.

Further, when the determination section 22 automatically performs switching of the learning model 25, for example, as in the example shown in Fig. 1C (however, the selection button 20b is unnecessary in this case), it is possible to adopt a mode in which the display field 20a of the selected learning model 25 (the first learning model 25a or the second learning model 25b), among the display fields 20a of all the learning models 25, is lighting displayed on the monitor so as to be discriminable from other learning models 25. Alternatively, it is possible to display only the display field 20a of the selected learning model 25 on the monitor (the display fields 20a of unselected learning models 25 are not displayed).

As described above, configuring such that the learning model 25 to be used for determination is displayed is effective, for example, such as when analyzing determination results (for example, when investigating the cause of deterioration of determination accuracy). Particularly, when the determination section 22 automatically performs switching of the learning model 25, if the learning model 25 to be used for determination is not displayed, it falls into a black-box state in which which learning model 25 is being used for determination is not recognizable at a glance, and therefore the configuration of display as described above is effective.

Further, in analyzing the determination results, it is also effective to store the learning model 25 used for determination, linked with process log data (including the training dataset) applied to the learning model 25 used for determination and determination results, for example, in a hard disk 27.

Incidentally, description has been made such that in the production process determination device 20 shown in Fig. 1B, the determination section 22 includes two learning models 25 (a first learning model 25a and a second learning model 25b), so that the learning model 25 is switched to either one learning model 25 based on, for example, the evaluation result of determination accuracy, and determination is performed by using only the selected one learning model 25; however, the present invention will not be limited to this.

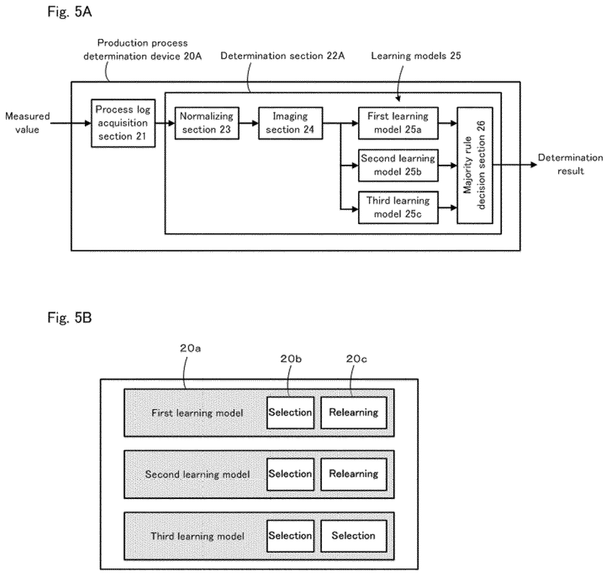

Figs. 5A and 5B are diagrams for showing a variant of the production process determination device. Fig. 5A is a block diagram for showing an outline configuration of the production process determination device according to the variant. Fig. 5B is a schematic diagram for showing a display example of a monitor screen of a computer constituting the production process determination device according to the variant.

A production process determination device 20A according to the variant shown in Fig. 5A, like the production process determination device 20 shown in Fig.

1B, includes a process log acquisition section 21 and a determination section 22A, and is constituted by, for example, a computer. Since the configuration of the process log acquisition section 21 is similar to that of the production process determination device 20 shown in Fig. 1B, description thereof will be omitted.

The determination section 22A shown in Fig. 5A also, like the determination section 22 shown in Fig. 1B, includes a normalizing section 23, an imaging section 24, and multiple learning models 25. However, the determination section 22A differs from the determination section 22 in that it includes an odd number (three or more) of learning models 25 (three, a first learning model 25a, a second learning model 25b, and a third learning model 25c in the example shown in Fig. 5A) as the multiple learning models 25. Moreover, the determination section 22A differs from the determination section 22 in that it includes a majority rule decision section 26. The normalizing section 23, the imaging section 24, the learning models 25, and the majority rule decision section 26 are each constituted by, for example, a memory such as ROM and RAM included in a computer, and a program which is stored in the memory and causes a CPU to execute actions as each section 23 to 26. The program may be in a mode to be stored in a hard disk 27 which is an external storage medium included in the production process determination device 20A, and to be read from the hard disk 27 into a RAM. Since the configurations of the normalizing section 23 and the imaging section 24 are similar to those of the production process determination device 20 shown in Fig. 1B, description will be omitted.

The determination section 22A of the production process determination device 20A according to the variant is configured to perform determination by using all of the first learning model 25a, the second learning model 25b, and the third learning model 25c. Therefore, for example, as shown in Fig. 5B, all of the display fields 20a of the selected learning models 25 (the first learning model 25a to the third learning model 25c) are lighting displayed on the monitor. Specifically, output values OUT are output from all of the first learning model 25a to the third learning model 25c, and are input to the majority rule decision section 26.

Then, the majority rule decision section 26 outputs a majority decision of the determination results of the first learning model 25a to the third learning model 25c as a final determination result. For example, when the output value OUT of the first learning model 25a is $0 \leq OUT < 0.5$ (to be determined as before the endpoint of etching), the output value OUT of the second learning model 25b is $0 \leq OUT < 0.5$ (to be determined as before the endpoint of etching), and the output value OUT of the third learning model 25c is $0.5 \leq OUT \leq 1$ (to be determined as after the endpoint of etching), a determination result indicating before the endpoint of etching will be output from the majority rule decision section 26 as the final determination result.

Although all of the three learning models 25 of the first learning model 25a to the third learning model 25c are used to perform determination in the example shown in Fig. 5A, this is not limiting. For example, when there are five learning models 25, it is also possible to adopt a mode in which determination is performed by selecting and using some learning models 25 such that determination is performed by using three learning models 25 out of the five learning models 25.

Further, it is also possible to adopt a mode which enables switching between a case of outputting a final determination result by using the majority rule decision section 26, and a case of outputting a determination result by using any of the learning models 25 without using the majority rule decision section 26, like the production process determination device 20 shown in Figure 1B.

Hereinafter, description will be made on one example of the result of a test in which a substrate W was etched by the substrate processing apparatus 10 of the substrate processing system 100 according to the first embodiment, and the endpoint of etching was determined (detected) by the first learning model 25a of the production process determination device 20 (the learning model 25 generated by performing machine learning by using only the training dataset obtained before shipping of the substrate processing apparatus 10).

In the above described test, first, nineteen substrates W (Si substrates) were etched by using $SF_6$ gas, and input data (image data) to the first learning model 25a was created for each sampling period of 1 second within the etching time of each substrate W (about 50 seconds from the etching start of the substrate W until reaching the end of overetching via the end of etching). Since a spectroscope was provided in the substrate processing apparatus 10 used in the above described test, whether the input data of each sampling period was input data created from process log data acquired before the endpoint of etching, or input data created from process log data acquired after the endpoint of etching was determined based on whether or not the intensity of light having an emission wavelength of SiF measured by the spectroscope was not more than a reference value. By using the training dataset collected as described above, the first learning model 25a was subjected to machine learning. When input data of the same training dataset was input to the first learning model 25a after the learning to determine whether it is before or after the endpoint of etching, a correct answer rate (number of correct answers/determination times $\times$ 100) as the determination accuracy was 99.89%. Incidentally, since time needed for performing determination once in the first learning model 25a was sufficiently less than the time of overetching, it is safely stated that there will be no problem even if etching is ended after the endpoint of etching is detected (it is determined to be after the endpoint of etching) by the production process determination device 20.

Next, in the above described test, other six (No. 1-1 to No. 1-6) substrates W (Si substrates) were etched with the same recipe by using $SF_6$ gas, and input data (image data) to the first learning model 25a was created for each sampling period of 1 second within the etching time of each substrate W. Then, the created input data was input to the first learning model 25a after the above described learning to determine whether it is before or after the endpoint of etching. On this occasion, like in the above described learning, by using the spectroscope provided in the substrate processing apparatus 10, whether the input data of each sampling period is before the endpoint of etching or after the endpoint of etching was determined.

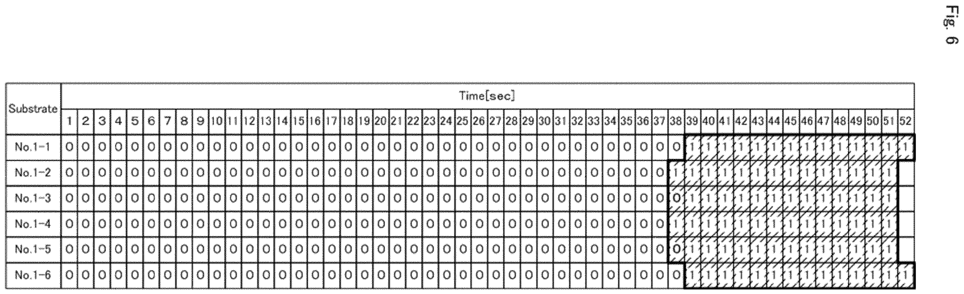

Fig. 6 shows results of the above described test. The symbol "0" shown in Fig. 6 indicates that it is determined to be before the endpoint of etching by the production process determination device 20, and the symbol "1" indicates that it is determined to be after the endpoint of etching by the production process determination device 20. In Fig. 6, a field which is hatched and surrounded by a thick line indicates that it was determined to be after the endpoint of etching by using the spectroscope.

As shown in Fig. 6, determination different from that by use of the spectroscope was only determination of the substrate W of No. 1-3 at a time point of 38 seconds, and determination of the substrate W of No. 1-5 at a time point of 38 seconds, and a correct answer rate as the determination accuracy was 99.35% (= 306/308 $\times$ 100). Therefore, it can be stated that according to the production process determination device 20 of the substrate processing system 100 according to the first embodiment, the endpoint of etching of the substrate W can be accurately detected.

<Second embodiment>

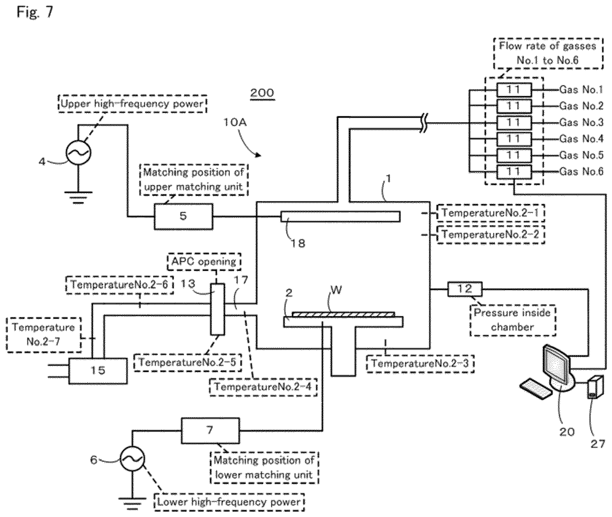

Fig. 7 is a schematic diagram for showing an outline configuration of a substrate processing system according to the second embodiment. Incidentally, in Fig. 7 as well, like in Fig. 1A described above, parameters to be measured are illustrated by surrounding them by a rectangle of broken line. In Fig. 7, illustration of the configuration corresponding to Fig. 1B described above is omitted.

As shown in Fig. 7, a substrate processing system 200 according to a second embodiment includes a substrate processing apparatus 10A and a production process determination device 20.

Hereinafter, points that differ from the substrate processing system 100 according to the first embodiment will be mainly described, and components similar to those of the substrate processing system 100 according to the first embodiment are given the same symbols and description thereof will be omitted.

The substrate processing apparatus 10A of the second embodiment including a chamber 1 and a mounting table 2 disposed in the chamber 1 is an apparatus for conducting plasma processing on a substrate W mounted on the mounting table 2. More specifically, the substrate processing apparatus 10A of the second embodiment is a plasma film deposition apparatus for capacitively coupled plasma (CCP) method, which forms a film on the substrate W as plasma processing.

For that reason, in contrast to the substrate processing apparatus 10 of the first embodiment, it includes, in place of the coil 3 (see Fig. 1A), an upper electrode 18 disposed to be opposed to, and in parallel with, the mounting table 2 in the chamber 1.

In the substrate processing apparatus 10A, after the substrate W which has been subjected to film deposition processing is transferred to the outside of the chamber 1, a film composition which adhered to the inside of the chamber 1 due to the film deposition processing is removed by cleaning. Specifically, the film composition adhered to the inside of the chamber 1 is removed by etching by use of plasma. As for the etching to be executed in cleaning, it is important to determine (detect) the endpoint of etching (endpoint of cleaning) to prevent excessive supply of processing gas for generating plasma.

Processing gas for generating plasma is supplied from a gas source (not shown) into the chamber 1 of the substrate processing apparatus 10A. Fig. 7 illustrates a configuration which is enabled to supply six kinds of processing gas of Gas No.1 to Gas No.6. However, the configuration will not be limited to a case in which all of the six kinds of processing gas are used when executing film deposition processing, and when cleaning the film composition adhered to the inside of the chamber 1, and it is possible to perform film deposition processing and cleaning by using any one or more kinds of processing gas.

High-frequency power (upper high-frequency power) is applied to the upper electrode 18 from the upper high-frequency power supply 4 via an upper matching unit 5. Moreover, high-frequency power (lower high-frequency power) is applied to the mounting table 2 from the lower high-frequency power supply 6 via a lower matching unit 7. As a result of this, processing gas supplied into the chamber 1 is turned into plasma, and the generated plasma moves toward the mounting table 2, thereby forming a film on the substrate W mounted on the mounting table 2. When cleaning the film composition after the film deposition processing, the generated plasma moves toward the inner surface of the chamber 1, and thereby the film composition adhered to the inside of the chamber 1 is removed by etching.

The substrate processing apparatus 10A of the second embodiment, in contrast to the substrate processing apparatus 10 of the first embodiment, does not include a chiller 8, a pressure/flow meter 9, a first pump (a turbo-molecular pump) 14, and a vacuum gauge 16.

In the substrate processing system 200 according to the second embodiment, the flow rate of each processing gas to be supplied is measured by a mass flow controller 11 provided in a flow path from the gas source to the chamber 1. Moreover, the temperature (Temperature No. 2-1 to No. 2-3 shown in Fig. 7) of a heater (not shown) provided at each appropriate place in the wall surface of the chamber 1 is measured by a known measurement instrument (not shown) such as a thermocouple. Further, pressure inside the chamber 1 is measured by a vacuum gauge 12.

Moreover, the upper high-frequency power applied by the upper high-frequency power supply 4, and matching position of the upper matching unit 5 (constants of variable capacitors and variable coils included in the upper matching unit 5) are measured respectively by a known measurement instrument (not shown).

Moreover, the lower high-frequency power applied by the lower high-frequency power supply 6, and matching position of the lower matching unit 7 (constants of variable capacitors and variable coils included in the lower matching unit 7) are measured respectively by a known measurement instrument (not shown).

Further, the temperature (Temperature No. 2-5 shown in Fig. 7) of an auto pressure controller 13, and temperature (Temperature No. 2-4, No. 2-6, and No. 2-7 shown in Fig. 7) of the heater (not shown) provided at each appropriate place of an exhaust pipe 17 are measured by a known measurement instrument (not shown) such as a thermocouple. Further, the APC opening of the auto pressure controller 13 is measured with a known measurement instrument (not shown) such as an encoder.

The production process determination device 20 included in the substrate processing system 200 according to the second embodiment has a similar configuration to that of the first embodiment, and is electrically connected with wire or wirelessly with a measurement instrument (for example, the mass flow controller 11) that measures each measured value as described above with reference to Fig. 7. The production process determination device 20 acquires measured data sequentially input from each measurement instrument at a predetermined sampling period (for example, 1 second), and thus acquired each measured value, and each set value corresponding to the each measured value are used as the process log data for detecting the endpoint of etching. The process log data to be used in the second embodiment also does not include either measured value or set value regarding the position of the substrate W outside of the substrate processing apparatus 10A.

In the second embodiment, although all the measured value shown in Fig. 7 is used as process log data for determination, the present invention will not be limited to this. However, it is preferable to use, at least, the APC opening and matching position of the upper matching unit 5 and/or the lower matching unit 7.

The endpoint of etching determined (detected) by the production process determination device 20 of the second embodiment is, in contrast to in the first embodiment, the endpoint of the etching to be executed for removing a film composition adhered to the inside of the chamber 1 after the film is formed on the substrate W.

Incidentally, in the second embodiment as well, like in the first embodiment, it is possible to adopt a production process determination device 20A according to the variant shown in Fig. 5A.

Hereinafter, description will be made on one example of the result of a test in which in the etching (cleaning) to be executed for removing a film composition adhered to the inside of the chamber 1 after a film is formed on the substrate W by the substrate processing apparatus 10A of the substrate processing system 200 according to the second embodiment, the endpoint of etching was determined (detected) by the first learning model 25a (the learning model 25 generated by performing machine learning by using only the training dataset obtained before shipping of the substrate processing apparatus 10A) of the production process determination device 20.

In the above described test, first, the inside of the chamber 1 was cleaned 13 times by using $C_4F_8$ gas, and input data (image data) to the first learning model 25a was created for each sampling period of 1 second within the etching time of each cleaning (about 150 seconds from the start of etching of the film composition adhered to the inside of the chamber 1 until reaching the end of overetching via the end of etching). Since a spectroscope was provided in the substrate processing apparatus 10A used in the above described test, whether the input data of each sampling period was input data created from process log data acquired before the endpoint of etching, or input data created from process log data acquired after the endpoint of etching was determined based on whether or not the intensity of light having an emission wavelength of F measured by the spectroscope was not less than a reference value. By using the training dataset collected as described above, the first learning model 25a was subjected to machine learning. When input data of the same training dataset was input to the first learning model 25a after the learning to perform determination, a correct answer rate as the determination accuracy was 99.39%. Incidentally, since time needed for performing determination once in the first learning model 25a was sufficiently less than the time of overetching, it is safely stated that there will be no problem even if etching is ended after the endpoint of etching is detected (it is determined to be after the endpoint of etching) by the production process determination device 20.

Next, in the above described test, the inside of the chamber 1 was cleaned five times (No. 2-1 to No. 2-5) at other timings with the same recipe by using $C_4F_8$ gas, and input data (image data) to the first learning model 25a was created for each sampling period of 1 second within the etching time of each cleaning. Then, the created input data was input to the first learning model 25a after the above described learning to determine whether it is before or after the endpoint of etching. On this occasion, like in the above described learning, by using the spectroscope provided in the substrate processing apparatus 10A, whether the input data of each sampling period is obtained before the endpoint of etching, or obtained after the endpoint of etching was determined.

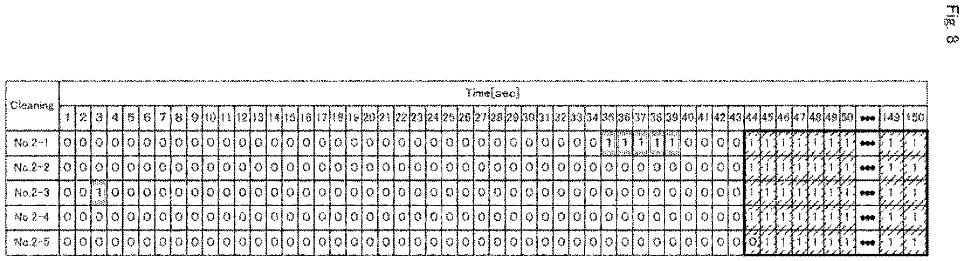

Fig. 8 shows results of the above described test. The symbol "0" shown in Fig. 8 indicates that it is determined to be before the endpoint of etching by the production process determination device 20, and the symbol "1" indicates that it is determined to be after the endpoint of etching by the production process determination device 20. In Fig. 8, a field which is hatched and surrounded by a thick line indicates that it was determined to be after the endpoint of etching by using the spectroscope.

As shown in Fig. 8, determinations different from the determination by use of the spectroscope were only the determination of Cleaning of No. 2-1 at a time point of 35 to 39 seconds, determination of Cleaning of No. 2-3 at a time point of 3 seconds, and determination of Cleaning of No. 2-5 at a time point of 44 seconds, and a correct answer rate as the determination accuracy was 99.1% (= 743/750 $\times$ 100). Therefore, it can be stated that according to the production process determination device 20 of the substrate processing system 200 according to the second embodiment, the endpoint of etching (cleaning) of a film composition adhered to the inside of the chamber 1 can be accurately detected.

Incidentally, in the first and the second embodiments described above, a configuration in which the determination section 22 includes a normalizing section 23 has been described as an example; however, the present invention will not be limited to this. It is also possible that the determination section 22 does not include the normalizing section 23, and process log data acquired by the process log acquisition section 21 is used as it is without being normalized to create input data.

Further, in the first and the second embodiments, a configuration in which the determination section 22 includes an imaging section 24 has been described as an example; however, the present invention will not be limited to this. It is also possible that the determination section 22 does not include the imaging section 24, and process log data acquired by the process log acquisition section 21 may be used as it is, or once normalized, as input data to the learning model 25 without being subjected to imaging.

Specifically, when imaging is not performed, for example, process log data $X_{ij}$ (i=1 to N, j=1 to M) shown in Fig. 2A or process log data after normalization $Y_{ij}$ (i=1 to N, j=1 to M) shown in Fig. 2B is to be input to the input layer of the learning model 25 shown in Fig. 3.

Further, in the first and the second embodiments, a configuration in which input data (image data) created at a predetermined sampling period (for example, 1 second) is used as the input data to the learning model 25 both at the time of learning and at the time of determination has been described as an example; however, the present invention will not be limited to this. For example, it is also possible to perform imaging of a graph representing changes in a predetermined time period (within a time period corresponding to multiple sampling periods) of process log data acquired at a predetermined sampling period, and use this image data as the input data to the learning model 25. Any of the above described image data will include a graph created from process log data spreading over before and after the endpoint of etching.

Further, in the first and the second embodiments, a configuration in which the first learning model 25a is generated by performing machine learning by using only the training dataset obtained before shipping of the substrate processing apparatus 10, 10A, and the second learning model 25b is generated by performing machine learning by using the training datasets obtained before and after shipping of the substrate processing apparatus 10, 10A has been described as an example; however, the present invention will not be limited to this. For example, the second learning model 25b may be generated by performing machine learning by using only the training dataset obtained after shipping of the substrate processing apparatus 10, 10A. Moreover, without being limited to using the training datasets before and after shipping, it suffices that the first learning model 25a and the second learning model 25b are generated by using mutually different training datasets.

Further, in the first and the second embodiments, a configuration in which the substrate processing apparatus 10, 10A includes a single chamber 1 for executing etching processing and one set of a first learning model 25a and a second learning model 25b are provided has been described as an example; however, the present invention will not be limited to this. For example, it is also possible to adopt a configuration in which the substrate processing apparatus 10, 10A includes multiple chambers 1, and when performing determination regarding production process for each chamber 1, the first learning model 25a and the second learning model 25b are provided in each chamber 1, and these are used in a switching manner. Further, it is also possible to adopt a configuration in which when performing determination regarding production process for each recipe, the first learning model 25a and the second learning model 25b are provided for each recipe, and these are used in a switching manner. The same applies to a case in which the first learning model 25a to the third learning model 25c are provided like in the production process determination device 20A according to the variant.

Further, in the first and the second embodiments, a configuration in which machine learning of the learning model 25 is performed by using both training datasets whose output is before the endpoint of etching (OUT = 0) and after the end point of etching (OUT = 1) has been described as an example; however, the present invention will not be limited to this. For example, it is also possible to perform machine learning of the learning model 25 by using only the training dataset whose output is before the endpoint of etching (OUT = 0), or by using only the training dataset whose output is after the endpoint of etching (OUT = 1).

Further, in the first and the second embodiments, a case in which the output of the training dataset a discrete value (OUT = 0 or 1), in other words a case in which the learning model 25 is a classification model (classifier) has been described as an example; however, the present invention will not be limited to this. For example, when the determination target is a continuous value such as a predicted value of etching depth, it is also possible to perform machine learning of the learning model 25 (that is, generating a learning model 25 which is a regression model) by using a training dataset whose output is a continuous value (for example, a value normalized between 0 to 1).

Further, in the second embodiment, a case in which the majority rule decision section 26 outputs a majority decision of determination results of the first learning model 25a to the third learning model 25c as a final determination result has been described as an example; however, the present invention will not be limited to this. For example, similarly to the above, when the determination target is a continuous value such as a predicted value of etching depth, it is also possible to adopt a mode in which an average value calculation section is provided in place of the majority rule decision section 26, and the average value calculation section calculates an average value of the output of the first learning model 25a to the third learning model 25c, which are configured to output a continuous value, and outputs the calculated average value as a final determination result.

Further, according to the production process determination device 20 of the first and the second embodiments, it is not always necessary to provide a spectroscope in the substrate processing apparatus 10, 10A itself, to which the production process determination device 20 is applied, and even when a spectroscope is provided, it may be used only at the time of learning of the learning model 25. The spectroscope may be removed after learning.

Therefore, compared to a conventional determination device in which a spectroscope is always necessary when detecting the endpoint of etching as described in Patent Literature 4, production cost and time and effort for maintenance will be reduced.

However, the present invention will not be limited to a mode in which a spectroscope is used at the time of learning of the learning model 25.

Generally, an optical window made of a transparent material such as silica glass is provided in a side wall of the chamber 1 to guide the light generated in the chamber 1 to a spectroscope placed outside the chamber 1. This optical window may be roughened by being etched by plasma in the chamber 1, or may be tarnished by reaction products in the chamber 1 adhering thereto. When the optical window is tarnished, the quantity of light detected by the spectroscope is reduced, and thereby detection accuracy of the endpoint of etching by the spectroscope may deteriorate. For this reason, for example, when a spectroscope is already provided in the existing substrate processing apparatus 10, 10A, it is also possible to adopt a mode in which detection of the endpoint of etching by the production process determination device 20 is used as an aid for detecting the endpoint of etching by the spectroscope (for example, usage for issuing an alarm).

Moreover, generally, an electrostatic chuck (not shown in Figs. 1A and 7) for electrostatically attracting a substrate W at the time of plasma processing is provided on the mounting table 2 of the substrate processing apparatus 10, 10A. When plasma processing is ended, the substrate W is moved upward by a lifting mechanism, and the substrate W is detached from the electrostatic chuck, detachment failure of substrate W may occur due to residual electrostatic force. The production process determination device 20 of the first and the second embodiments is also applicable when determining (detecting) such lifting abnormality.

In the case of the production process determination device 20 that determines lifting abnormality, it may be configured such that, for example, whether or not transfer abnormality has occurred at a predetermined timing and at a predetermined position is sensed by using a sensor, etc. for sensing the substrate W, for the substrate W to be transferred to the outside of the chamber 1 after detachment from the electrostatic chuck, and process log data when transfer abnormality has not occurred (when normal) is used to create a training dataset. That is, machine learning of the learning model 25 may be performed by using only the training dataset in which output of the learning model 25 is normal.

Further, in the first and the second embodiments, a case in which the substrate processing apparatus 10, 10A to which the production process determination device 20 is applied is a plasma processing apparatus has been described as an example; however, the present invention will not be limited to this. For example, it can be applied to a sacrificial layer etching apparatus by using anhydrous HF gas and alcohol, a sacrificial layer etching apparatus by using $XeF_2$ gas, and the like, which is conventionally only capable of time etching (etching which is executed only for a predetermined certain time period).

[Reference Signs List]

| 1 | Chamber, |
|---|---|
| 2 | Mounting table, |
| 10, 10A | Substrate processing apparatus, |
| 20 | Production process determination device, |
| 21 | Process log acquisition section, |
| 22, 22A | Determination section, |
| 23 | Normalizing section, |
| 24 | Imaging section, |
| 25 | Learning model, |
| 26 | Majority rule decision section, |

25a     First learning model,
25b     Second learning model,
25c     Third learning model,
100, 200     Substrate processing system, and
W     Substrate.

## Claims

1. A production process determination device for a substrate processing apparatus, for performing determination regarding production process in the substrate processing apparatus, the production process determination device comprising:

   a process log acquisition section that is configured to acquire process log data of the substrate processing apparatus; and
   a determination section that is configured to create input data based on the process log data and to perform determination regarding production process in the substrate processing apparatus based on the input data, wherein
   the determination section includes multiple learning models each of which is configured to receive the input data and each of which is configured to output a determination result regarding the production process, and
   the multiple learning models are generated by performing machine learning by use of mutually different training datasets, and wherein
   the determination section is capable of switching a learning model to be used for determination among the multiple learning models.

2. The production process determination device for a substrate processing apparatus according to claim 1, wherein
   the determination section is configured to evaluate determination accuracy of each of the multiple learning models by using a test dataset, and thereafter to perform determination by using a learning model exhibiting highest determination accuracy.

3. The production process determination device for a substrate processing apparatus according to claim 1, wherein
   the determination section is configured to output a majority decision of determination results of the multiple learning models as a final determination result.

4. The production process determination device for a substrate processing apparatus according to any of claims 1 to 3, wherein
   the multiple learning models include a learning model generated by performing machine learning by use of only a training dataset obtained in an initial state of the substrate processing apparatus, and a learning model generated by performing machine learning by use of a training dataset including a training dataset obtained after elapse of the initial state of the substrate processing apparatus.

5. A substrate processing system comprising:

   a substrate processing apparatus; and
   the production process determination device according to any of claims 1 to 4.

6. A production process determination method for a substrate processing apparatus, comprising:

   a process log acquisition step of acquiring process log data of a substrate processing apparatus; and
   a determination step of creating input data based on the process log data acquired by the process log acquisition step, and performing determination regarding production process in the substrate processing device based on the input data, wherein
   in the determination step, multiple learning models generated by performing machine learning by use of mutually different training datasets are prepared, and the input data is input to at least any one learning model of the multiple learning models, and determination result regarding the production process is output from the at least any one learning model.

7. A learning model group, comprising
   multiple learning models, each of which is configured to receive input data created based on process log data of a substrate processing apparatus, and each of which is configured to output a determination result regarding production process in the substrate processing apparatus, wherein
   the multiple learning models are generated by performing machine learning by use of mutually different training datasets.

8. A generation method of a learning model group including multiple learning models, wherein
   each of the multiple learning models is configured to receive input data created based on process log data of a substrate processing apparatus, and to output a determination result regarding production process in the substrate processing apparatus, and wherein
   the multiple learning models are generated by performing machine learning by use of mutually different training datasets.

9. A program for causing a computer to execute the process log acquisition step and the determination step included in the production process determination method for a substrate processing apparatus

**EP 3 819 930 A1**

according to claim 6.

EP 3 819 930 A1

Fig. 1A

Fig. 1B

Fig. 1C

Fig. 2A

<Process log data>

| Process time | Parameter 1 | ••• | Parameter N |
|---|---|---|---|
| 1[sec] | $X_{11}$ | ••• | $X_{N1}$ |
| 2[sec] | $X_{12}$ | ••• | $X_{N2}$ |
| ⋮ | ⋮ | ••• | ⋮ |
| M[sec] | $X_{1M}$ | ••• | $X_{NM}$ |

Normalization →

<Process log data after normalization>

| Process time | Parameter 1 | ••• | Parameter N |
|---|---|---|---|
| 1[sec] | $Y_{11}$ | ••• | $Y_{N1}$ |
| 2[sec] | $Y_{12}$ | ••• | $Y_{N2}$ |
| ⋮ | ⋮ | ••• | ⋮ |
| M[sec] | $Y_{1M}$ | ••• | $Y_{NM}$ |

| Maximum value | $MAX_1$ | ••• | $MAX_N$ |
|---|---|---|---|
| Minimum value | $MIN_1$ | ••• | $MIN_N$ |

$$Y_{ij} = (X_{ij} - MIN_i) / (MAX_i - MIN_i)$$
$$i = 1 \sim N$$
$$j = 1 \sim M$$

Fig. 2B

<Process log data after normalization>

| Process time | Parameter 1 | ••• | Parameter N |
|---|---|---|---|
| 1[sec] | $Y_{11}$ | ••• | $Y_{N1}$ |
| 2[sec] | $Y_{12}$ | ••• | $Y_{N2}$ |
| ⋮ | ⋮ | ••• | ⋮ |
| M[sec] | $Y_{1M}$ | ••• | $Y_{NM}$ |

Imaging →

<Image data>

Value of process log data after normalization $Y_{ij}$

Process time

Kind of process log data (parameters 1 to N)

Fig. 2C

$A_{11}$ $A_{12}$ ••• $A_{1K}$

$A_{21}$
$A_{31}$

$A_{ij}$ Average density value $I_{ave}(A_{ij})$

$A_{K1}$ $A_{KK}$

Fig. 3

25

(Input layer)

(Intermediate layer)

$I_{ave}(A_{11})$ →

$I_{ave}(A_{12})$ →

$I_{ave}(A_{KK-1})$ →

$I_{ave}(A_{KK})$ →

(Output layer)

→ OUT

<Output value OUT>

(1) At time of learning : OUT=0 (before endpoint of etching)
OUT=1 (after endpoint of etching)

(2) At time of determination : 0≦OUT<0.5 (before endpoint of etching)
0.5≦OUT≦1 (after endpoint of etching)

Fig. 4A

```
  Start                          Start
    │                              │
    ▼                              ▼
┌──────────────────┐      ┌──────────────────┐
│ Training dataset D1│     │ Training dataset D2│
│   is prepared     │      │   is prepared     │
└──────────────────┘      └──────────────────┘
    │                              │
    ▼                              ▼
┌──────────────────┐      ┌──────────────────┐
│ First learning    │      │ Second learning   │
│ model 25a is      │      │ model 25b         │
│ subjected to      │      │ is subjected to   │
│ learning by       │      │ learning by       │
│ using training    │      │ using training    │
│ dataset D1        │      │ dataset D2        │
└──────────────────┘      └──────────────────┘
    │                              │
    ▼                              ▼
   End                            End
```

Fig. 4B

```
                    Start
                      │
                      ▼
              ╱───────────────╲          Second learning model 25b
             ╱  Learning model  ╲ ──────────  is selected
             ╲  25 is switched   ╱                    │
             ╲ by determination ╱                     │
              ╲    section 22  ╱                       │
               ╲─────────────╱                        │
                      │                                │
        First learning model 25a                      │
               is selected                            │
                      │                                │
                      ▼                                ▼
        ┌──────────────────────┐      ┌──────────────────────┐
        │ Input data is input   │      │ Input data is input   │
        │ to first              │      │ to second             │
        │ learning model 25a to │      │ learning model 25b to │
        │ perform determination │      │ perform determination │
        └──────────────────────┘      └──────────────────────┘
                      │                                │
                      │◄───────────────────────────────┘
                      ▼
                    End
```

Fig. 5A

Production process
determination device 20A    Determination section 22A    Learning models 25

| | Process log acquisition section 21 | Normalizing section 23 | Imaging section 24 | First learning model 25a | |
|---|---|---|---|---|---|

Measured value → Process log acquisition section 21 → Normalizing section 23 → Imaging section 24 → First learning model 25a → Majority rule decision section 26 → Determination result

Second learning model 25b

Third learning model 25c

Fig. 5B

20a          20b        20c

| First learning model | Selection | Relearning |
|---|---|---|
| Second learning model | Selection | Relearning |
| Third learning model | Selection | Selection |

Fig. 6

Fig. 7

Fig. 8

## INTERNATIONAL SEARCH REPORT

| International application No. |
|---|
| PCT/JP2020/008659 |

**A. CLASSIFICATION OF SUBJECT MATTER**
H01L 21/3065(2006.01)i
FI: H01L21/302 103
According to International Patent Classification (IPC) or to both national classification and IPC

**B. FIELDS SEARCHED**

Minimum documentation searched (classification system followed by classification symbols)
H01L21/3065

| Documentation searched other than minimum documentation to the extent that such documents are included in the fields searched | |
|---|---|
| Published examined utility model applications of Japan | 1922–1996 |
| Published unexamined utility model applications of Japan | 1971–2020 |
| Registered utility model specifications of Japan | 1996–2020 |
| Published registered utility model applications of Japan | 1994–2020 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 5-190457 A (FUJI ELECTRIC CO., LTD.) 30.07.1993 (1993-07-30) entire text, all drawings | 1-9 |
| A | JP 2005-200730 A (ITAGAKI KINZOKU KK) 28.07.2005 (2005-07-28) entire text, all drawings | 1-9 |
| A | JP 2018-45559 A (FUJITSU LTD.) 22.03.2018 (2018-03-22) entire text, all drawings | 1-9 |
| A | JP 2016-192007 A (NEC CORP.) 10.11.2016 (2016-11-10) entire text, all drawings | 1-9 |

☐ Further documents are listed in the continuation of Box C.  ☒ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 14 May 2020 (14.05.2020) | 26 May 2020 (26.05.2020) |

| Name and mailing address of the ISA/ | Authorized officer |
|---|---|
| Japan Patent Office<br>3-4-3, Kasumigaseki, Chiyoda-ku,<br>Tokyo 100-8915, Japan | |
| | Telephone No. |

Form PCT/ISA/210 (second sheet) (January 2015)

## INTERNATIONAL SEARCH REPORT
Information on patent family members

International application no.

PCT/JP2020/008651

| Patent Documents referred in the Report | Publication Date | Patent Family | Publication Date |
|---|---|---|---|
| JP 5-190457 A | 30 Jul. 1993 | (Family: none) | |
| JP 2005-200730 A | 28 Jul. 2005 | (Family: none) | |
| JP 2018-45559 A | 22 Mar. 2018 | US 2018/0082215 A1 entire text, all drawings | |
| JP 2016-192007 A | 10 Nov. 2016 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009534854 A
- JP 2017195365 A
- JP 2018178157 A
- JP 4101280 B